# EUROPÄISCHE PATENTSCHRIFT

(11) **EP 3 115 099 B1**
(45) Veröffentlichungstag und Bekanntmachung des Hinweises auf die Patenterteilung: **04.09.2019**
(21) Anmeldenummer: 15175700.2
(22) Anmeldetag: 07.07.2015
(51) Int. Cl.: B01D 15/38, C02F 1/469, C23C 16/455, C02F 103/34, C02F 101/30, C02F 1/44, B01D 71/02, B01D 67/00, B01D 61/42, B01D 71/68, C23C 16/04, C02F 1/461

(54) **VERFAHREN ZUR ELEKTROFILTRATION UND ELEKTRO-SORPTION MITTELS EINER METALLBESCHICHTETEN POLYMERMEMBRAN UND VORRICHTUNG DAFÜR**
METHOD FOR ELECTROFILTRATION AND ELECTRO SORPTION BY MEANS OF A METAL COATED POLYMERMEMBRANE AND APPARATUS THEREFOR
PROCEDE D'ELECTROFILTRATION ET ELECTROSORPTION A L'AIDE D'UNE MEMBRANE POLYMERE METALLISEE ET APPAREIL ADAPTE

(43) Veröffentlichungstag der Anmeldung: 11.01.2017
(73) Patentinhaber: I3 Membrane GmbH, 22525 Hamburg (DE)
(72) Erfinder: Dr. Brinke-Seiferth, Stephan, 22525 Hamburg (DE); Prof. Dr. Kolitsch, Andreas, 01833 Elbersdorf (DE)
(74) Vertreter: Raffay & Fleck

(56) Entgegenhaltungen:
- EP-A1- 0 380 266
- EP-A1- 0 860 888
- WO-A1-02/051874
- WO-A1-2011/057341
- DE-A1- 10 013 457
- DE-A1-102011 012 832
- US-A1- 2013 240 361

## Beschreibung

Die vorliegende Erfindung betrifft eine metallbeschichtete Polymermembran, ein Verfahren zu deren Herstellung, eine Elektrofiltration- oder -sorptionsvorrichtung sowie ein Verfahren zur Elektrofiltration und Elektrosorption mittels einer metallbeschichteten Polymembran.

Mikroporöse Membranen sind seit langer Zeit bekannt. Diese werden vornehmlich aus Polymeren gefertigt und zur Wasseraufbereitung (Abwasser, Trinkwasser, Industriewässer) als auch in der Pharmaindustrie zur Herstellung von ultrareinem Wasser als auch in der Medizintechnik als Sterilfilter oder Atemfilter eingesetzt. Die Einsatzbereiche sind vielfach und sehr divergent. Mikroporöse Membranen haben in der Regel eine Porengröße zwischen 0,01 µm und 10 µm und halten entsprechend dieser Porengrößen Stoffe zurück.

Mikroporöse Filter werden typischerweise eingesetzt, um in Wasser gelöste Stoffe zu separieren und ein klares Filtrat zu erhalten. Dies geschieht in der Regel mechanisch über die Porengröße. Alle Stoffe, die größer sind als die Größe der Poren, werden mechanisch zurückgehalten. Neben dieser Eigenschaft gibt es noch einen weiteren Mechanismus, der zum Rückhalt von Stoffen bei dem Passieren der Membran stattfindet. Es handelt sich hierbei um eine nicht definierte Adsorption durch die Materialien, aus denen die Membran selbst besteht, wie beispielsweise Polyethersulfon, Polypropylen oder Polyvenylidenflouorid (PVDF). Dabei adsorbieren unterschiedliche Materialien unterschiedlich stark verschiedene gelöste Stoffe ("Analyte Loss Due to Membrane Filter Adsorption as Determined by High-Performance Liquid Chromatography" M. Carlson and R.D. Thompson, Journal of Chromatographic Science, Vol. 38, Feb. 2000).

Eine gerichtete Adsorption von Stoffen, die kleiner als die Porengröße der mikroporösen Membran, mittels der Materialeigenschaften des Membranmaterials wird durch die Behandlung der chemischen Komposition des Membranmaterials erreicht. Eine positive Ladung wird beispielsweise durch Verbindung des Membranmaterials mit positiv geladenen quaternären Ammoniumverbindungen erzeugt. Positiv geladene Membranen sind aus US 5,282,971 oder aus US 7,396,465 B2, negativ geladene Membranen aus US 7,132,049 B2 bekannt. Beispielsweise werden positiv geladene mikroporöse Membranen eingesetzt um Bakterien mechanisch zurückzuhalten und positiv geladene Stoffe passieren zu lassen, um eine ungerichtete, nicht quantifizierbare Adsorption durch das Membranmaterial zu vermeiden. Positiv und auch negativ geladene Membranen werden aber auch eingesetzt, um Proteine durch Adsorption zu binden und zu konzentrieren. Positiv geladene mikroporöse Membranen werden auch eingesetzt, um neben der Filtration Endotoxine und Viren über Adsorption zu binden wie beispielsweise in DE 1999981099947A1 dargestellt.

Aus der CH 678403 ist eine mit Metall beschichtete Membran mit möglicherweise leicht porösen Durchgängen zwischen Makroporen auf einer und Mikroporen auf der metallischen Seite bekannt. Auch sind, beispielsweise aus der DE 101 64 214 A1 Metallmembranen mit tunnelartigen Durchgängen bekannt. Diese unterscheiden sich von im Sprachgebrauch der Anmeldung porösen Durchgängen, wie sie beispielsweise von porösen Polymermembranen bekannt sind, dadurch, dass sie außerhalb des eigentlichen Durchgangskanals innerhalb der Membran keine Kavitäten ausbilden. Porös ist somit nicht gleichzusetzen mit der Aussage, dass die Membran Poren, also Durchgänge, wie beispielsweise in der DE 101 64 214 A1 aufweist. Poröse Durchgänge weisen somit eine Oberfläche innerhalb der Membran auf, die die Oberfläche eines runden Tunnels mit gleicher Porengröße durch eine gleich dicke Membran deutlich übersteigt, mindestens um 50 %, insbesondere um ein Vielfaches, insbesondere mindestens um das 3-Fache.

Des Weiteren ist es aus der WO 1999/22843 A1 bekannt, eine Polymermembran mit Metall zu besputtern. Aus der WO 2011/057341 sind darüber hinaus Verfahren, insbesondere mittels ALD, zur Herstellung metallbeschichteter Membranen bekannt.

Auch ist es aus de US 4,857,080 bekannt, eine Membran mit einer Metallbeschichtung zu verschließen. Die EP 0 380 266 A1 offenbart eine Kombination aus Metallgitter und poröser Membran durch Anlegen von Wechselspannungspulsen zu reinigen Eine weitere Form der Adsorption ist die Elektrosorption. Die Elektrosorption erfolgt durch Herstellung eines elektrisch geladenen Feldes an Oberflächen durch Anlegen einer positiven und negativen Spannung an zwei Elektroden. Eine Kombination aus Elektrosorption und ultraporöser Filtration ist in "Removal of arsenic and humic substances (HSs) by electro-ultrafiltration (EUF)" (Weng, Y.-H. et al. , Chem. Eng. R&D Vol.77, July 1999, Pages 461-468). Dabei wird durch Herstellung eines elektrischen Feldes durch eine externe Elektrode, die nahe an einer Ultrafiltrationsmembran positioniert ist, eine Adsorptionssteigerung von negativ geladenem Arsen (V) während der Filtration von Arsen belasteten Wassers durch eine Ultrafiltration von 30 % auf 90 % erreicht. Ein ähnlicher Einsatz von Elektrosorption in Kombination mit Membranen ist in US2013/0240361 A1 beschrieben. In einer Kombination von Stoffen mit stark adsorptiven Eigenschaften und deren Regeneration durch elektrische Ladung wird die Reinigung von Dialysewasser beschrieben. Das Verfahren wird in Kombination mit einem Dialysemembranfilter betrieben.

Eine Elektrosorptionsmembran ist in EP0872278A1 beschrieben. Hier wird eine Keramikmembran mit einer leitfähigen Schicht aus pyrolytischer Kohle versehen. Dabei werden die Poren mit pyrolytischer Kohle verschlossen und die keramische Oberfläche dann über hohe Temperatur durch Umwandlung der keramischen Oberfläche zu Carbid leitfähig gemacht. Mit dieser keramischen Membran wurden Salze adsorptiv über Elektrosorption an der Oberfläche gebunden.

Neben den Vorteilen der durch chemische Behandlung positiv oder negativ geladenen Membranen, nämlich der Kombination aus mechanischer Filtration und Adsorption, weisen diese auch einen Nachteil auf. Da die Ladung nicht variiert werden kann, können die Stoffe, die adsorptiv gebunden wurden, nach Beladung der Membran, nur durch eine Verschiebung der Ladung durch eine zu passierende Lösung, in der Regel durch pH-Wertveränderung, wieder von der Membran entfernt oder gewonnen werden. Insbesondere bei der Gewinnung von Wirkstoffen wie beispielsweise Proteinen durch Konzentration stellt dies einen zusätzlichen Aufwand dar.

Eine mögliche Elektrosorption an der leitfähigen Oberfläche einer keramischen Membran erlaubt eine flexiblere Sorption von Stoffen, ist allerdings sehr aufwendig in der Herstellung. Dabei werden die Poren der Membran innerhalb des Verfahrens zur Herstellung der leitfähigen Oberfläche verschlossen, um in einem eine anschließenden Herstellungsschritt mittels sehr hoher Temperaturen die keramische Oberfläche mit einer leitfähigen Carbidschicht zu versehen.

Aufgabe ist es, eine effektivere Vorrichtung und ein effektiveres Verfahren zur Elektrofiltration und/oder Elektrosorption anzugeben.

Gelöst werden die Aufgaben durch ein Verfahren nach Anspruch 1, sowie durch eine Elektrofiltrations- und/oder Elektrosorptionsvorrichtung nach Anspruch 5. Die abhängigen Ansprüche 2 bis 4und 6 bis 8 geben vorteilhafte Weiterbildungen an.

Die Abscheidung mittels Magnetronsputtern ermöglicht das großflächige Herstellen von dünnen Schichten mit einer homogenen Schichtdicke und komplexem Schichtaufbau. Grundlage der Magnetronabscheidung ist eine Plasmaentladung in Inertgasatmosphäre, z. B. Argon, welche durch ein statisches Magnetfeld verstärkt wird (A. Anders, Handbook of Plasma Immersion Ion Implantation and Deposition, Wiley-VHC, 2004). Die Ionen des Prozessgases werden Kathode beschleunigt und schlagen aus dieser beim Auftreffen Atome heraus. Folglich muss die Kathode (Target) aus dem Material bestehen, welches abgeschieden werden soll. Die aus dem Target ausgeschlagenen Atome kondensieren dann auf dem zu beschichteten Substrat und bilden eine kontinuierliche dünne Schicht. Diese Schichtdicke kann von wenigen Nanometern bis hin zu mehreren Mikrometern gesteuert erzeugt werden. Neben runden Magnetrons sind vor allem für die Beschichtung großer Flächen, z. B. in der Architekturglasbeschichtung, rechteckige Varianten mit mehreren Metern Länge weit verbreitet. Hier durch können Oberflächen von Membranen beschichtet werden.

Die Atomlagenabscheidung (engl.: atomic layer deposition - ALD) ist ein Verfahren zur Abscheidung atomar dünner und konformer Oberflächenschichten aus der Gasphase mittels einer selbstbegrenzenden Oberflächenreaktion (S.M. George, Chem.Rev. 110, 2010, 111-130). Häufig werden zweistufige Reaktionsprozesse zwischen zwei Reaktanten verwendet. Dabei wird der erste gasförmige Precursor in die Prozesskammer geleitet und an der Oberfläche adsorbiert. Dies führt gleichzeitig zur Selbstbegrenzung des Prozesses, da an der Oberfläche nur eine Monolage des Precursor anhaften kann. Die überschüssigen Reste werden in einem anschließenden Spülschritt mit einem inerten Gas, häufig Argon, aus der Reaktionskammer entfernt. Anschließend wird das zweite Precursorgas in die Reaktionskammer geleitet und ebenfalls an der Oberfläche adsorbiert. Nun kommt es zur chemischen Reaktion der beiden adsorbierten Precursor, was zur Bildung einer eine Monolage dicken Schicht des Reaktionsproduktes führt. Die gasförmigen Reaktionsprodukte werden dann wiederum mit Inertgas aus der Reaktionskammer gespült. Durch diesen vierstufigen Prozess reagieren die Precursoren ausschließlich auf der Oberfläche und nicht in der Gasphase, wodurch sehr dünne und homogene Schichten entstehen. Durch Wiederholung der Schritte können so definiert Atomlage für Atomlage an den für die Gase zugängigen Oberflächen aufgebracht werden. Die Adsorption der Reaktionsprodukte aus der Gasphase ermöglicht die sehr homogene Beschichtung komplexer Strukturen mit einem hohen Aspektverhältnis und ist deshalb in der heutigen Halbleiterindustrie sehr verbreitet.

Der Vorteil dieses Verfahrens liegt, wie der Erfinder erkannt hat, darin, dass auch die porösen Durchgänge, Öffnungen und Kavitäten einer Polymermembran effektiv beschichtet werden können und somit eine inerte und/oder biozide poröse Membran erzeugt werden kann. Auch kann dadurch eine Membran mit sehr großer leitender Oberfläche zur Elektroadsorption oder -filtration erzeugt werden.

Hinsichtlich der metallbeschichteten Polymermembran und deren Herstellung kann eine Polymermembran (beispielsweise Polysulfon, Polyethersulfon, Polypropylen oder Polyvinylidenfluorid) mittels des Atomlagenabscheidungsverfahrens mit einer dünnen Schicht Metall versehen werden. Dabei wird die Aufenthaltszeit der Membran im Prozess so niedrig gewählt, dass die Temperatur unter 200 °C verbleibt und die Polymermembran in ihrer ursprünglich chemischen Struktur nicht beeinflusst wird. Als Beispiel wurde eine Polyethersulfonmembran mit mikroporöser Struktur mit einer 20 nm dünnen Schicht aus Aluminium mittels versehen. An dieser Membran wurden Porositätsuntersuchungen durchgeführt. Die folgende Tabelle zeigt die Ergebnisse der Porositätsmessung der Membran zum einen im Originalzustand zum anderen mit einer definiert dicken Schicht von 20 nm Aluminium.

**Tab.1.: Porengrößen einer mikroporösen Polyethersulfonmembran im Original und mit einer 20 nm dicken Aluminiumschicht.**

| | Polyethersulfonmembran | | |
|---|---|---|---|
| | 20 nm Beschichtung Al | Original | Differenz % |
| **Bubble point Porengröße (µm)** | 0,51 | 0,56 | 8,5 |
| **Mittlere Porengröße (µm)** | 0,41 | 0,43 | 6,1 |
| **Kleinste Porengröße (µm)** | 0,37 | 0,39 | 5,5 |

Es ist zu erkennen, dass die Porosität der Membran zu unter 10 % beeinflusst wird. Zur Herstellung einer mit Metall beschichteten Polymermembran kann:
a. eine Polymermembran bereitgestellt
b. die Polymermembran mittels ALD Verfahren mit Metall beschichtet werden, wobei insbesondere die Temperatur der Polymermembran 200 °C nicht übersteigt.

Dabei wird die Metallbeschichtung zumindest flächig auf einer ersten Seite der Polymermembran und/oder zumindest auf den von einer Seite gaszugänglichen Oberflächen aufgebracht, bis die Schichtdicke der Beschichtung aus Metall der Polymermembran bezogen auf die initiale Bubble Point Pore und/oder die mittlere Porengröße der unbeschichteten Polymermembran zwischen 1 % und 45 % beträgt.

Die Beschichtung wird insbesondere porös und insbesondere unmittelbar aufgebracht. Unmittelbar heißt, dass die Beschichtung mittels ALD unmittelbar auf die Polymermembran aufgebracht wird. In der Regel wird dazu zunächst ein Precursor aufgebracht und dann die eigentliche Metallschicht aufgebracht. Mit besonderem Vorteil handelt es sich bei dem Precursor um einen Aluminiumoxid enthaltenden, sodass die Beschichtung bei anschließender Abscheidung von Metall aus Metall und Aluminiumoxid besteht.

Die Beschichtung wird als porös bezeichnet, nicht weil sie selbst zwingend eine poröse Oberfläche aufweist, sondern weil sie die poröse Oberfläche der Polymermembran weitgehend widerspiegelt und nicht verschließt.

Die von einer Seite gaszugänglichen Oberflächen können auch die gesamten Oberflächen der Membran sein. Auch können die Poren vorher ganz oder teilweise verschlossen werde, um die von einer Seite gaszugänglichen Oberflächen zu reduzieren.

Auch kann eine Beschichtung von beiden Seiten so erfolgen, dass die von zumindest einer von zwei Seiten der Polymermembran gaszugänglichen Oberflächen beschichtet werden. So kann beispielsweise eine beidseitig beschichtete Membran erzeugt werden, deren innerer Bereich nicht beschichtet ist, da die Poren zuvor verschlossen wurden. Anschließend können die Poren wieder geöffnet werden.

So lässt sich eine beschichtete Polymermembran mit nur geringfügig reduzierter Porosität und gleichzeitig guter Leitfähigkeit erzeugen. Wird die Polymermembran nicht nur auf einer Seite, sondern vollständig nach obigem Verfahren mit Metall beschichtet und somit in Metall gekapselt, also auch die Oberflächen der porösen Durchgänge mit Metall insbesondere vollständig, beschichtet, entsteht eine inerte und sehr widerstandsfähige Membran.

Als Metall für die Beschichtung kommen insbesondere Kupfer, Aluminium, Silber, Gold, Nickel, Platin und/oder Wolfram oder Legierungen beinhaltend Kupfer, Aluminium, Silber, Gold, Nickel, Platin und/oder Wolfram infrage.

Besonders bevorzugt wird eine Beschichtung, die inert und/oder biozid ist, insbesondere durch Verwendung von biozidem und/oder inertem Metall zur Beschichtung. Biozide Beschichtungen lassen sich beispielsweise unter Verwendung von Silber in der Beschichtung erreichen. Inerte Beschichtungen lassen sich beispielsweise durch die Verwendung von Wolfram zur Beschichtung erreichen.

Als Polymermembran kommen beispielsweise Membranen aus Polysulfon, Polypropylen, Polyethersulfon, Polyethermid, Polyacrylnitril, Polycarbonat, Polyethylenterephtalat, Polyvenylidenflourid (PVDF) und/oder Polytetraflourethylen oder solche Polysulfon, Polypropylen, Polyethersulfon, Polyethermid, Polyacrylnitril, Cellulose, Polycarbonat, Polyethylenterephtalat, Polyvenylidenflourid (PVDF) und/oder Polytetraflourethylen beinhaltend infrage.

Mit besonderem Vorteil wird Metall solange abgeschieden, bis die Schichtdicke der Beschichtung aus Metal der Polymermembran bezogen auf die initiale Bubble Point Pore und/oder die mittlere Porengröße der unbeschichteten Polymermembran zwischen 1 % und 45 % beträgt.

Bei diesen Werten lässt sich eine hohe Stabilität und Leitfähigkeit mit gutem Durchsatz und hoher Porosität vereinen.

Bevorzugt wird Metall solange abgeschieden, bis die Porosität der Polymermembran mit Beschichtung aus Metall bezogen auf die initiale Bubble Point Pore und/oder die mittlere Porengröße gegenüber der unbeschichteten Polymermembran zwischen 1 % und 50% , insbesondere 1 und 20 % verringert ist. Auch diesen Werten lässt sich eine hohe Stabilität und Leitfähigkeit mit gutem Durchsatz und hoher Porosität vereinen.

Bevorzugt wird Metall solange abgeschieden, bis die initiale Bubble Point Pore und/oder die mittlere Porengröße der Polymermembran mit Beschichtung aus Metall 0,01 bis 10*µ*m beträgt. Dazu wird die Polymermembran mit einer initialen Bubble Point Pore und/oder mittleren Porengröße von mehr als 0,01 bis 10*µ*m gewählt.

Vorteilhafterweise wird die Polymermembran auf der ersten und einer der ersten Seite gegenüberliegenden zweiten Seite flächig mit Metall porös unmittelbar beschichtet.

Dadurch lässt sich, beim Auslassen der Beschichtung der porösen Durchgänge sowie der Kanten soweit, dass keine leitende Verbindung zwischen den beiden Seiten entsteht, eine Membran mit zwei elektrisch leitenden und gegeneinander isolierten Oberflächen schaffen. Dies kann beispielsweise durch vorheriges Verschließen und anschließendes Öffnen der Poren erreicht werden. Werden hingegen die porösen Durchgänge ebenfalls vollständig beschichtet und gegebenenfalls auch die Kanten, entsteht eine vollständig gekapselte und sehr widerstandsfähige Membran.

Mit Vorteil wird Metall solange abgeschieden, bis die Dicke der Beschichtung aus Metall oder die mittlere Dicke der Beschichtung aus Metall mindestens 1nm, insbesondere mindestens 5 nm und maximal 50nm beträgt. Bei diesen Werten lässt sich eine hohe Stabilität und bei mindestens 5 nm auch eine gute Leitfähigkeit mit gutem Durchsatz und hoher Porosität vereinen.

Die Porengröße der unbeschichteten Polymermembran wird zwischen 0,01 und 15*µ*m, insbesondere bis 10*µ*m, gewählt. Hier lässt sich ein Verschließen der Poren mit Metall besonders gut verhindern.

Mit Vorteil wird Metall solange abgeschieden, bis die Dicke der Beschichtung aus Metall der Poren innerhalb der Membran oder die mittlere Dicke der Beschichtung aus Metall der Poren innerhalb der Membran mindestens 1 und maximal 50nm

Für die Lösung der erfinderischen Aufgabe hinsichtlich der Elektrofiltration oder -sorption wird verfahrensgemäß
a. eine Polymermembran mit flächiger und poröser Beschichtung aus Metall zumindest auf einer ersten Seite der Polymermembran bereitgestellt, wobei die Porengröße der unbeschichteten Polymermembran zwischen 0,01 und 15*µ*m liegt;
b. eine Gegenelektrode bereitgestellt;
c. die Polymermembran und die Gegenelektrode in einem Gefäß zur Aufnahme von Flüssigkeit angeordnet, ohne dass zwischen Ihnen eine leitende elektrische Verbindung besteht;
d. Flüssigkeit in das Gefäß eingefüllt;
e. eine Spannung zwischen der Beschichtung aus Metall der Polymermembran und der Gegenelektrode angelegt;
f. die Flüssigkeit zumindest teilweise aus dem Gefäß entfernt oder zumindest teilweise die Membran passiert;
g. die Spannung umgepolt.

Wird in Schritt f alle Flüssigkeit entfernt, wird vorteilhafterweise vor oder nach Schritt g Flüssigkeit zugeführt, dies ist ansonsten möglich. Die Schritte werden insbesondere in der angegebenen Reihenfolge durchgeführt, wobei Schritte d und e auch in umgekehrter Reihenfolge erfolgen können.

Bei der Polymermembran mit Metallbeschichtung handelt es sich um eine metallbeschichtete oder mit Metall beschichtete Membran, wie oben stehend beschrieben. Diese eignen sich besonders gut, insbesondere, wenn auch die porösen Durchgänge mit Metall beschichtet sind. Da die elektrisch aktive Oberfläche dann deutlich größer ausfällt. Es können aber auch andere metallbeschichtete Polymermembranen verwendet werden.

Insbesondere ist bei der Verwendung von Polymermembranen mit inerter Beschichtung die zur Metallbeschichtung so auf die Flüssigkeit abgestimmt, dass sie bei Kontakt mit dieser inert ist.

Mit besonderem Vorteil wird die Gegenelektrode entweder durch eine weitere flächige, poröse Beschichtung aus Metall auf einer zweiten, der ersten Seite gegenüberliegenden Seite gebildet, wobei die flächigen Beschichtungen aus Metall gegeneinander durch die Polymermembran isoliert sind, oder durch eine unter Zwischenlage eines isolierenden und permeablen Spacers angeordnete permeable Elektrode, insbesondere gebildet durch ein metallisches Netz.

Vorteilhafterweise wird die Porosität der Polymermembran mit Beschichtung aus Metall mit bezogen auf die initiale Bubble Point Pore und/oder die mittlere Porengröße gegenüber der unbeschichteten Polymermembran zwischen 1 % und 50% , insbesondere 1 und 20 % verringert gewählt. Dabei ist eine zuverlässige Leitfähigkeit bei gleichzeitig großer Porosität gegeben.

Mit Vorteil wir die Polymermembran derart gewählt, dass die Dicke der Beschichtung aus Metall 1nm, insbesondere 5 bis 50nm beträgt. Dabei ist eine zuverlässige Leitfähigkeit bei gleichzeitig großer Porosität gegeben.

Mit besonderem Vorteil wird eine Referenzelektrode zu Messzwecken bereitgestellt und das Potenzial an der Referenzelektrode gemessen.

Vorteilhafterweise wird neben Polymermembran mit Metallbeschichtung, die als Elektrode verwendet wird, und Gegenelektrode sowie gegebenenfalls Referenzelektrode mindestens eine weitere Elektrode, insbesondere mindestens eine weitere Polymermembran mit Metallbeschichtung, insbesondere wie oben stehend erläutert als weitere Elektrode, vorgesehen. Diese zusätzliche Elektrode wird ebenfalls im Gefäß und elektrisch von der Polymermembran mit Metallbeschichtung und der Gegenelektrode angeordnet, insbesondere in Schritt c.

Insbesondere wird an die mindestens eine weitere Elektrode eine Spannung angelegt, die so gewählt ist, dass das Potenzial der Gegenelektrode zwischen dem Potenzial der Polymermembran mit Metallbeschichtung und der mindestens einen weiteren Elektrode zu liegen kommt. Insbesondere wird die Gegenelektrode im Gefäß zwischen der Polymermembran mit Metallbeschichtung und der mindestens einen weiteren Elektrode angeordnet.

In diesem Fall kann es auch sinnvoll sein, mehrere Referenzelektroden einzusetzen und jeweils zwischen den Elektroden und/oder Gegenelektrode anzuordnen.

Es wurden Versuche zur Elektrosorption an einer Polyethersulfonmembran durchgeführt. Dazu wurde eine Laborfiltrationsmembran mit einem Durchmesser von d = 47 mm mit einer 15-nm-Schicht Aluminium mittels Magnetronsputtern versehen. An die Aluminiumoberfläche wurde ein Kupferkabel geklebt und mit einem isolierenden Lack versehen. Das verbleibende Kabel war ca. 30 cm lang und isoliert. Die Membran wurde in eine handelsübliche Unterdruckfiltrationseinheit eingebracht. Der Überstand wurde mit Reinwasser gefüllt und in dem Überstand eine Gegenelektrode aus Platin eingebracht.

In den Überstand wurden Endotoxine eingebracht, sodass der Überstand eine Endotoxinkonzentration von 1.000 IE (Internationale Einheiten Endotoxin) aufwies. Die Filtration erfolgte ohne Druck. Es erfolgte eine Filtration der Membran im Originalzustand ohne Beschichtung und eine Filtration mit einer Membran einer Beschichtung von 15 nm. An die beschichtete Membran wurde eine Spannung von + 500 mV angelegt. Die Ergebnisse sind in der folgenden Tabelle dargestellt.

| | Konzentration Endotoxin in EU/ml | | ml |
|---|---|---|---|
| | Vorlage | Auffanggefäß | Probenvolumen |
| Filter ohne Beschichtung | 1000 | 952,5 | 100 |
| Filter mit Beschichtung bei + 500 mV | 1000 | 0,3 | 50 |

Es ist deutlich zu erkennen, dass über die geladene Aluminiumbeschichtung Endotoxine fast vollständig adsorbiert werden, sodass die Konzentration nahe null ist. Die Polymermembran im Originalzustand ohne Metallbeschichtung, aber auch auch die metallbeschichtete Polymermembran ohne Spannung adsorbiert wenig.

Die Schichtdicke der Metallschicht auf der Membran beeinflusst die verbleibende Größe der Poren. Beispielsweise würde bei einer Mikrofiltrationsmembran mit einer mittleren Porengröße von 0,1 µm eine Schichtdicke von 25 nm zu einer rechnerischen Verminderung der Porengröße auf ca. 0,05 µm führen, die von 40 nm zu einer Verminderung auf 0,02µm führen. Dies führt zu einer deutlichen Verringerung der Porosität. Statt eine Schichtdicke von 40 nm bei einer Mikrofiltrationsmembran aufzutragen, ist es in diesem Beispiel meist sinnvoller eine Ultrafiltrationsmembran von 0,05 µm Porengröße zu wählen und mit einer Schichtdicke von 15 nm zu versehen, die dann rechnerisch auch zu einer Porengröße von 0,02 µm führt. Dadurch kann eine deutlich höhere Porosität erreicht werden.

Gegenständlich wird die Aufgabe gelöst durch Elektrosorptions- und/oder Elektrofiltrationsvorrichtung beinhaltend eine Gegenelektrode und eine Polymermembran mit flächiger und poröser Beschichtung aus Metall auf zumindest einer Seite der Polymermembran und eine Kontaktierung der Beschichtung aus Metall zur Anlage einer Spannung gegenüber der Gegenelektrode, wobei die Porengröße der unbeschichteten Polymermembran zwischen 0,01 und 15*µ*m liegt.

Bei der Gegenelektrode handelt es sich entweder um eine weitere flächige, poröse Beschichtung aus Metall auf einer zweiten, der ersten Seite gegenüberliegenden Seite oder um eine unter Zwischenlage eines isolierenden und permeablen Spacers angeordnete permeable Elektrode, insbesondere gebildet durch ein metallisches Netz.

Die Elektrosorptions- und/oder Elektrofiltrationsvorrichtung kann vorteilhafterweise eine weitere Elektrode enthalten.

Die Vorrichtung kann auch eine Vorrichtung zur Erzeugung einer Spannung beinhalten, die insbesondere so angeordnet ist, dass sie ein Potenzial zwischen Metallbeschichtung der Polymermembran und Gegenelektrode erzeugen kann.

Gegenelektrode und Polymermembran mit flächiger und poröser Beschichtung aus Metall sind insbesondere gegeneinander elektrisch isoliert.

Die Elektrosorptions- und/oder Elektrofiltrationsvorrichtung weist dazu insbesondere ein Gefäß zur Anordnung und/oder Durchleitung von Flüssigkeit auf, indem die Polymermembran und die Gegenelektrode elektrisch voneinander isoliert angeordnet sind.

Die Elektrosorptions- und/oder Elektrofiltrationsvorrichtung kann eine oder mehrere Referenzelektroden beinhalten.

Sie kann vorteilhafterweise auch mindestens eine weitere Elektrode wie oben in Bezug auf das Elektrosorptions- und/oder Elektrofiltrationsverfahren beschrieben enthalten. Auch die weiteren in Bezug zu diesem Verfahren beschriebenen gegenständlichen Merkmal lassen sich vorteilhaft in der Elektrosorptions- und/oder Elektrofiltrationsvorrichtung umsetzten.

Bei der Polymermembran mit Metallbeschichtung handelt es sich vorteilhafterweise um eine metallbeschichtete oder erfindungsgemäße mit Metall beschichtete Membran, wie oben stehend beschrieben. Diese eignen sich besonders gut, insbesondere, wenn auch die porösen Durchgänge mit Metall beschichtet sind. Da die elektrisch aktive Oberfläche dann deutlich größer ausfällt. Es können aber auch andere metallbeschichtete Polymermembranen verwendet werden.

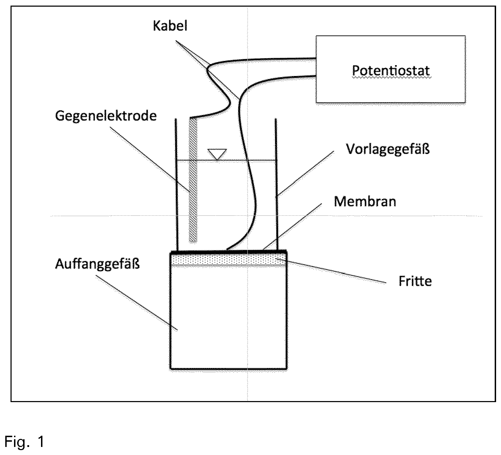

Eine erfindungsgemäße Elektrofiltrationsvorrichtung ist rein exemplarisch in der Figur 1 gezeigt. Mit dieser kann das erfindungsgemäße Elektrofiltrationsverfahren durchgeführt werden.

Die Flüssigkeit wird in das Vorlagengefäß eingefüllt und durch die Membran, gebildet durch eine metallbeschichtete Polymermembran unter Anlage einer Spannung zwischen Elektrode, die durch die Membran gebildet ist, und Gegenelektrode in das Auffanggefäß filtriert. Die Fritte dient zur Stabilisierung der Membran.

## Patentansprüche

1. Verfahren zur Elektrosorption und/oder Elektrofiltration umfassend die folgenden Schritte
a. Bereitstellen einer Polymermembran mit flächiger und poröser Beschichtung aus Metall zumindest auf einer ersten Seite der Polymermembran, wobei die Porengröße der unbeschichteten Polymermembran zwischen 0,01 und 15*µ*m liegt;
b. Bereitstellen einer Gegenelektrode;
c. Anordnen der Polymermembran und der Gegenelektrode in einem Gefäß zur Aufnahme von Flüssigkeit;
d. Einfüllen von Flüssigkeit in das Gefäß;
e. Anlegen einer Spannung zwischen der Beschichtung aus Metall der Polymermembran und der Gegenelektrode;
f. Zumindest teilweises Entfernen der Flüssigkeit aus dem Gefäß oder zumindest teilweises passieren lassen der Flüssigkeit durch die Membran;
g. Umpolen der Spannung.

2. Verfahren nach Anspruch 1, wobei die Gegenelektrode entweder durch eine weitere flächige, poröse Beschichtung aus Metall auf einer zweiten, der ersten Seite gegenüberliegenden Seite gebildet wird, wobei die flächigen Beschichtungen aus Metall gegeneinander durch die Polymermembran isoliert sind, oder durch eine unter Zwischenlage eines isolierenden und permeablen Spacers angeordnete permeable Elektrode, insbesondere gebildet durch ein metallisches Netz, gebildet wird.

3. Verfahren nach einem der vorstehenden Ansprüche, **dadurch gekennzeichnet, dass** die Porosität der Polymermembran mit Beschichtung aus Metall bezogen auf die initiale Bubble Point Pore und/oder die mittlere Porengröße gegenüber der unbeschichteten Polymermembran zwischen 1 % und 50 %, insbesondere 1 und 20 % verringert ist.

4. Verfahren nach einem der vorstehenden Ansprüche, **dadurch gekennzeichnet, dass** die Dicke der Beschichtung aus Metall 5 bis 50nm beträgt.

5. Elektrosorptions- und/oder Elektrofiltrationsvorrichtung beinhaltend eine Polymermembran mit flächiger und poröser Beschichtung aus Metall auf zumindest einer Seite der Polymermembran und eine Kontaktierung der Beschichtung aus Metall, wobei die Porengröße der unbeschichteten Polymermembran zwischen 0,01 und 15*µ*m liegt und beinhaltend eine Gegenelektrode, wobei die Gegenelektrode entweder durch eine weitere flächige, poröse Beschichtung aus Metall auf einer zweiten, der ersten Seite gegenüberliegenden Seite gebildet wird oder durch eine unter Zwischenlage eines isolierenden und permeablen Spacers angeordnete permeable Elektrode, insbesondere gebildet durch ein metallisches Netz, gebildet ist.

6. Elektrosorptions- und/oder Elektrofiltrationsvorrichtung nach Anspruch 5, **dadurch gekennzeichnet, dass** die Porosität der Polymermembran mit Beschichtung aus Metall bezogen auf die initiale Bubble Point Pore und/oder die mittlere Porengröße gegenüber der unbeschichteten Polymermembran zwischen 1 % und 50 %, insbesondere 1 und 20 % verringert ist.

7. Elektrosorptions- und/oder Elektrofiltrationsvorrichtung nach einem der Ansprüche 5 bis 6, **dadurch gekennzeichnet, dass** die Dicke der Beschichtung aus Metall 5 bis 50nm beträgt.

8. Elektrosorptions- und/oder Elektrofiltrationsvorrichtung nach einem der Ansprüche 5 bis 7, **dadurch gekennzeichnet, dass** die Beschichtung und insbesondere die Polymermembran mit der Beschichtung inert und/oder biozid ist.

## Claims

1. A process for electrosorption and/or electrofiltration comprising the following steps
a. Providing a polymer membrane with a flat and porous coating of metal at least on a first side of the polymer membrane, wherein the pore size of the uncoated polymer membrane is between 0.01 and 15µm
b. Providing a counter electrode;
c. Placing the polymer membrane and the counter electrode in a vessel for the storing of liquid;
d. Filling up the vessel with liquid;
e. Applying a voltage between the metal coating of the polymer membrane and the counter electrode;
f. Removing at least a portion of the liquid from the vessel or allowing at least a portion of the liquid to pass through the membrane;
g. Reversing the polarity of the voltage.

2. The process according to claim 1, wherein the counter electrode is formed either by a further flat, porous coating of metal on a second side opposite the first side, wherein the flat coatings of metal are insulated from one another by the polymer membrane, or by a permeable electrode, in particular formed by a metallic network, arranged with the interposition of an insulating and permeable spacer.

3. The process according to one of the previous claims, **characterised in that** the porosity of the metal-coated polymer membrane is reduced by between 1% and 50%, in particular 1 and 20%, relative to the initial bubble point pore and/or the average pore size compared with the uncoated polymer membrane.

4. The process according to one of the previous claims, **characterised in that** the thickness of the metal coating is 5 to 50 nm.

5. An electrosorption and/or electrofiltration device comprising a polymer membrane having a sheet-like and porous coating of metal on at least one side of the polymer membrane and contacting the coating of metal, the pore size of the uncoated polymer membrane being between 0.01 and 15µm and comprising a counter electrode, wherein the counter electrode is either formed by a further flat, porous coating of metal on a second side opposite the first side or is formed by a permeable electrode arranged with the interposition of an insulating and permeable spacer, in particular formed by a metallic network.

6. The electrosorption and/or electrofiltration device according to claim 5, **characterised in that** the porosity of the metal-coated polymer membrane is reduced by between 1% and 50%, in particular 1 and 20%, relative to the initial bubble point pore and/or the average pore size compared with the uncoated polymer membrane.

7. The electrosorption and/or electrofiltration device according to any of claims 5 to 6, **characterised in that** the thickness of the metal coating is 5 to 50nm.

8. The electrosorption and/or electrofiltration device according to any of claims 5 to 7, **characterised in that** the coating and in particular the polymer membrane with the coating is inert and/or biocidal.

## Revendications

1. Procédé d'électrosorption et/ou d'électrofiltration comprenant les étapes suivantes
a. Fourniture d'une membrane polymère présentant un revêtement métallique plat et poreux au moins sur un premier côté de la membrane polymère, dans lequel la taille des pores de la membrane polymère non revêtue est comprise entre 0,01 et 15µm
b. Fourniture d'une contre-électrode;
c. Mise en place de la membrane polymère et de la contre-électrode dans un récipient pour le contenir du liquide;
d. Remplissage du récipient avec du liquide;
e. Application d'une tension entre le revêtement métallique de la membrane polymère et la contre-électrode;
f. Extraction d'au moins une partie du liquide du récipient ou laisser passer au moins une partie du liquide à travers la membrane;
g. Inversion de la polarité de la tension.

2. Procédé selon la revendication 1, dans lequel la contre-électrode est formée soit par un autre revêtement métallique plat et poreux sur un deuxième côté opposé au premier côté, les revêtements métalliques plats étant isolés les uns des autres par la membrane polymère, soit par une électrode perméable, en particulier formée par un réseau métallique, disposée avec interposition d'une entretoise isolante et perméable.

3. Procédé selon l'une des revendications précédentes, **caractérisé en ce que** la porosité de la membrane polymère revêtue de métal est réduite de 1% à 50%, en particulier de 1 à 20%, par rapport au point de bulle initial et/ou à la taille moyenne des pores par rapport à la membrane polymère non revêtue.

4. Procédé selon l'une des revendications précédentes, **caractérisé en ce que** l'épaisseur du revêtement métallique est de 5 à 50 nm.

5. Dispositif d'électrosorption et/ou d'électrofiltration comprenant une membrane polymère ayant un revêtement métallique en forme de feuille et poreux sur au moins un côté de la membrane polymère et en contact avec le revêtement métallique, la taille des pores de la membrane polymère non revêtue étant comprise entre 0,01 et 15 µm et comprenant une contre électrode, dans lequel la contre électrode est formée soit par un autre revêtement métallique plat et poreux sur un second côté opposé au premier côté soit est formée par une électrode perméable disposée avec interposition d'une entretoise isolante et perméable, formé notamment par un réseau métallique.

6. Dispositif d'électrosorption et/ou d'électrofiltration selon la revendication 5, **caractérisé en ce que** la porosité de la membrane polymère revêtue de métal est réduite de 1 % à 50%, en particulier de 1 à 20%, par rapport au point de bulle initial et/ou à la taille moyenne des pores par rapport à la membrane polymère non revêtue.

7. Dispositif d'électrosorption et/ou d'électrofiltration selon l'une quelconque des revendications 5 à 6, **caractérisé en ce que** l'épaisseur du revêtement métallique est de 5 à 50 nm.

8. Dispositif d'électrosorption et/ou d'électrofiltration selon l'une quelconque des revendications 5 à 7, **caractérisé en ce que** le revêtement et en particulier la membrane polymère avec le revêtement est inerte et/ou biocide.
